# FASCICULE DE BREVET EUROPEEN

(11) **EP 2 803 167 B1**
(45) Date de publication et mention de la délivrance du brevet: **17.05.2017**
(21) Numéro de dépôt: 13700640.9
(22) Date de dépôt: 09.01.2013
(51) Int. Cl.: H04L 12/10, G06F 13/14, H04L 9/00

(54) **DISPOSITIF DE CONNEXION VIA UNE LIAISON ETHERNET DE DEUX EQUIPEMENTS ET STATION D'ACCUEIL D'UN DE CES EQUIPEMENTS**
VORRICHTUNG ZUM VERBINDEN ZWEIER GERÄTETEILE ÜBER EINE ETHERNETVERBINDUNG UND ANDOCKSTATION FÜR EINEN SOLCHEN GERÄTETEIL
DEVICE FOR CONNECTING TWO PIECES OF EQUIPMENT VIA AN ETHERNET LINK AND A DOCKING STATION FOR ONE OF SAID PIECES OF EQUIPMENT

(30) Priorité: 09.01.2012 FR 1250211
(43) Date de publication de la demande: 19.11.2014
(73) Titulaire: Safran Electronics & Defense, 92100 Boulogne-Billancourt (FR)
(72) Inventeur: HAURY, Christian, 92100 Boulogne-Billancourt (FR); GUILLOT, François, 92100 Boulogne-Billancourt (FR); COURTEILLE, Jean-Marie, 92100 Boulogne-Billancourt (FR)
(74) Mandataire: Lavialle, Bruno François Stéphane
(86) Numéro de dépôt international: PCT/EP2013/050320
(87) Numéro de publication internationale: WO 2013/104683

(56) Documents cités:
- US-A1- 2009 015 237
- US-B2- 7 873 845
- MENDELSON G: "All you need to know about Power over Ethernet (PoE) and the IEEE 802.3af Standard", POWERDSINE WHITE PAPER, , 1 juin 2004 (2004-06-01), pages 1-24, XP002474228, Extrait de l'Internet: URL:http://www.powerdsine.com
- MD MUSTAFIZUR RAHMAN ET AL: "Medium access control for power line communications: an overview of the IEEE 1901 and ITU-T G.hn standards", IEEE COMMUNICATIONS MAGAZINE, IEEE SERVICE CENTER, PISCATAWAY, US, vol. 49, no. 6, 1 juin 2011 (2011-06-01), pages 183-191, XP011355195, ISSN: 0163-6804, DOI: 10.1109/MCOM.2011.5784004

## Description

La présente invention concerne un dispositif de connexion de deux équipements électroniques l'un à l'autre, tels que des unités informatiques comme un serveur et un terminal ou un périphérique.

Il est connu de relier des équipements électroniques par un dispositif de connexion mettant en oeuvre une liaison ETHERNET. Le dispositif de connexion comporte deux interfaces ETHERNET qui sont reliées entre elles par une ligne montante et une ligne descendante et qui sont agencées pour être reliées chacune à l'un des équipements de manière à transmettre des données en mode différentiel. Ceci permet la transmission de données en haut débit, classiquement maintenant entre 100 et 1000 Mb/s.

Dans certaines applications, il est nécessaire de prévoir une liaison sécurisée pour la transmission d'informations sensibles. Or, les liaisons ETHERNET classiques du type ci-dessus présentent, de par leur principe même, un niveau de sécurité relativement faible sans prévoir des modifications complexes des interfaces et une limitation du débit. Il est alors généralement prévu une deuxième liaison entre les équipements, ladite liaison étant établie au moyen d'un second dispositif de connexion associé aux équipements. Or, dans les applications aéronautiques embarquées, l'adjonction d'un second dispositif de connexion est pénalisante au niveau du poids.

Il est en outre nécessaire de prévoir un raccordement des équipements au réseau électrique, mis en oeuvre au moyen de câbles dont le poids vient s'ajouter à ceux des dispositifs de connexion. XP002474228 divulgue la technique Power over Ethernet (PoE). Selon cette technique un dispositif de connexion entre un premier équipement électronique et un deuxième équipement électronique comporte deux interfaces de type ETHERNET reliées entre elles par une ligne montante et une ligne descendante et agencées pour être reliées chacune à l'un des équipements et transmettre des données en mode différentiel. Deux modules alimentation sont associés chacun à l'un des équipements. XP011355195 divulgue la communication de données par modulation d'un courant alternatif d'alimentation. Un but de l'invention est de fournir un moyen de liaison entre équipements électroniques ne présentant pas, ou que peu, les inconvénients précités.

A cet effet, on prévoit, selon l'invention, un dispositif de connexion d'un premier équipement électronique à un deuxième équipement électronique, comportant deux interfaces de type ETHERNET reliées entre elles par une ligne montante et une ligne descendante et agencées pour être reliées chacune à l'un des équipements et transmettre des données en mode différentiel, deux modules d'alimentation associés chacun à l'un des équipements et montés en mode commun entre les lignes montante et descendante pour transmettre un signal porteur d'alimentation en courant alternatif, et deux modules de transmission secondaire associés chacun à un des modules d'alimentation et agencés pour permettre une transmission de données par modulation du signal porteur d'alimentation.

Ainsi, le dispositif de l'invention permet d'avoir une liaison de transmission de données, de type ETHERNET, en mode différentiel sur les lignes montante et descendante et une liaison de transmission de données en mode commun sur les lignes montante et descendante. Le dispositif de connexion assure en outre l'alimentation de l'un des deux équipements via l'autre équipement. Ceci permet un gain de masse et de volume. La liaison Ethernet autorise en outre des distances de communication relativement importantes.

De préférence, le module de transmission secondaire du premier équipement est agencé pour effectuer une modulation par saut de phase.

Ce mode de modulation est particulièrement bien adapté pour l'émission de données vers le deuxième équipement.

De préférence encore, le module de transmission secondaire du deuxième équipement est agencé pour transmettre des données par modulation du courant consommé et, avantageusement, la modulation du courant consommé est synchronisée avec un flux de données montant pour coder les données en fonction d'un positionnement temporel de pics de courant consommé par rapport au flux de données montant.

Ceci permet de manière simple l'émission de données vers le premier équipement.

Selon deux modes alternatifs de communication bidirectionnelle :
- les modules de transmission sont agencés pour assurer une transmission bidirectionnelle simultanée,
- les modules de transmission sont agencés pour assurer une transmission bidirectionnelle par alternance.

D'autres caractéristiques et avantages de l'invention ressortiront à la lecture de la description qui suit de modes de réalisation particuliers non limitatifs de l'invention.

Il sera fait référence aux dessins annexés, parmi lesquels :
- la figure 1 est une vue schématique du circuit du dispositif conforme à l'invention,
- la figure 2 est un schéma illustrant une chronologie de transmission de données.

En référence aux figures, le dispositif de connexion conforme à l'invention est destiné à permettre le raccordement d'un premier équipement électronique 100, ici un équipement maître de type serveur informatique, à un deuxième équipement électronique 101, ici un équipement électronique esclave de type terminal informatique. L'invention est néanmoins utilisable pour d'autres types d'équipements électroniques communicants.

L'équipement 100 et l'équipement 101 sont tous deux pourvus d'un port de raccordement externe de type ETHERNET.

Le dispositif de connexion de l'invention, généralement désigné en 1, comporte une unité de raccordement maître 10.1 et une unité de raccordement esclave 10.2 qui sont des interfaces ETHERNET reliées l'une à l'autre par une liaison 2 de type Ethernet, comportant une ligne d'émission 2.a et une ligne de réception 2.b. La ligne d'émission 2.a et la ligne de réception 2.b sont chacune formée d'une paire de conducteurs d'un câble Ethernet.

L'unité de raccordement maître 10.1 possède un port de raccordement externe à l'équipement 100 et est reliée à la ligne d'émission 2.a et à la ligne de réception 2.b via un transformateur d'isolement 13.1, 14.1 respectivement.

L'unité de raccordement esclave 10.2 possède un port de raccordement externe à l'équipement 101 et est reliée à la ligne d'émission 2.a et à la ligne de réception 2.b via un transformateur d'isolement 13.2, 14.2 respectivement.

L'unité de raccordement maître 10.1 est en outre reliée à un module d'alimentation 15.1 monté en mode commun entre la ligne d'émission 2.a et la ligne de réception 2.b pour émettre, via une isolation galvanique, un courant alternatif sur la liaison. L'isolation galvanique est assurée par un transformateur d'isolement 16.1 dont le secondaire est relié au point milieu du secondaire du transformateur 13.1 et au point milieu du primaire du transformateur 14.1.

Le module d'alimentation 15.1 est agencé pour fournir un courant ayant une fréquence suffisamment basse pour ne pas perturber les communications et suffisamment élevée pour limiter la taille du transformateur 16.1. La plage de fréquences retenue est ici comprise entre 2kHz et 100kHz, voire entre 2kHz et 10kHz. Le transformateur est agencé pour procurer ici de préférence un isolement galvanique (courant continu, courant alternatif basses et hautes fréquences) supérieur à 1500 V.

Le module d'alimentation 15.1 comprend ainsi un convertisseur continu alternatif isolé assurant l'émission de puissance sur la liaison 2 et qui est associé à un organe de régulation. L'organe de régulation est agencé pour réaliser un asservissement sur une valeur efficace de tension et un asservissement sur une forme d'onde du courant (en sinus) en sortie d'un module d'alimentation 15.1 relié à l'unité de raccordement esclave 10.2. L'asservissement sur la forme d'onde est réalisé pour limiter le risque de perturbations électromagnétiques. Ceci permet d'éviter des défauts d'alimentation, tels que des bruits de commutation (« glitches ») que l'équipement 101 pourrait ne pas supporter et qui obligerait à prévoir des éléments de filtrage encombrants au niveau de l'équipement 101.

L'unité de raccordement 10.2 est reliée au module d'alimentation 15.2 qui est monté en mode commun entre la ligne d'émission 2.a et la ligne de réception 2.b pour recevoir, via une isolation galvanique, le courant alternatif sur la liaison. L'isolation galvanique est assurée par un transformateur d'isolement 16.2 dont le primaire est relié au point milieu du primaire du transformateur 13.2 et au point milieu du secondaire du transformateur 14.2. Le module d'alimentation 15.2 est isolé et assure ainsi la réception de puissance depuis la liaison 2.

Le module d'alimentation 15.2 de l'unité de raccordement périphérique comprend un circuit redresseur, généralement désigné en 18, qui comprend un pont de diodes et un condensateur.

Le dispositif de l'invention assure la transmission d'une tension d'alimentation en signal porteur d'alimentation alternatif, en mode commun sur la ligne d'émission et la ligne de réception (le V+ est transmis sur une des paires du câble Ethernet 2 et le V-est transmis sur l'autre paire). Dans une application aéronautique, on estime la puissance maximale transmissible à 30 VA (28 Veff et au moins 1 Aeff entre 10 kHz et 100 kHz). La régulation du signal d'alimentation se fait sur deux paramètres : la tension efficace et la forme d'onde du courant. Au niveau de la source, la tension efficace est mesurée et le générateur est asservi pour fournir une tension prédéterminée, par exemple 28V, quelle que soit la forme du courant. Puis, un asservissement est réalisé sur la forme d'onde du courant. Il s'agit plus particulièrement d'un asservissement sur une forme en sinus comme indiqué plus haut. Ceci permet de simplifier la partie réceptrice en limitant les perturbations électromagnétiques. En particulier, les bruits de commutation des diodes du pont de diodes du circuit redresseur 18 sont limités voir éliminés sans recourir à des éléments de filtrages encombrants. La fréquence choisie pour le signal, ici comprise de préférence entre 2 kHz et 100 kHz, est suffisamment basse pour ne pas perturber les communications et suffisamment élevée pour minimiser la taille du transformateur.

En courant continu, l'isolation est assurée par les transformateurs et, en courant alternatif, le couplage capacitif est minimisé du fait de la présence de transformateurs montés en frontal. Les couplages capacitifs sont faibles dans les transformateurs de couplage et il est possible d'ajouter des inductances mode commun en série sur chaque ligne 2.a, 2.b pour compenser la baisse de leur impédance en haute fréquence.

Ainsi, le calculateur de l'équipement électronique esclave est alimenté par l'équipement électronique maître. Seul l'équipement électronique maître dispose donc d'une alimentation, ce qui allège la structure du système informatique et en simplifie la maintenance.

A chaque module d'alimentation 15.1, 15.2 est associé un module de transmission secondaire 17.1, 17.2 agencé pour transmettre des données par modulation du signal porteur d'alimentation.

Le module de transmission secondaire 17.1 comprend un circuit de commande 18 de type microcontrôleur ou FPGA, relié d'une part à des interrupteurs 19 d'un pont de puissance 20 relié au primaire du transformateur 16.1 pour la transmission de données et d'autre part un organe de mesure du courant émis pour la réception de données.

Le module de transmission secondaire 17.2 est relié aux lignes 2a, 2b via un transformateur d'isolement 21 pour la réception des données. Le transformateur d'isolement 21 a un primaire relié au point milieu du primaire du transformateur 13.2 et au point milieu du secondaire du transformateur 14.2 et un secondaire relié au module de transmission secondaire 17.2. Le module de transmission secondaire 17.2 est en outre relié à un interrupteur 22 monté entre les branches de sortie du pont de diodes en série avec une résistance 23.

En fonctionnement, le module de transmission secondaire 17.1 transforme les données A en un flux B bi-phase (bi-phase L) et pilote les interrupteurs 19 pour moduler de manière correspondante la tension du signal porteur d'alimentation.

Le module de transmission secondaire 17.2 se synchronise sur le flux bi-phase B et transforme ledit flux pour récupérer les données transmises.

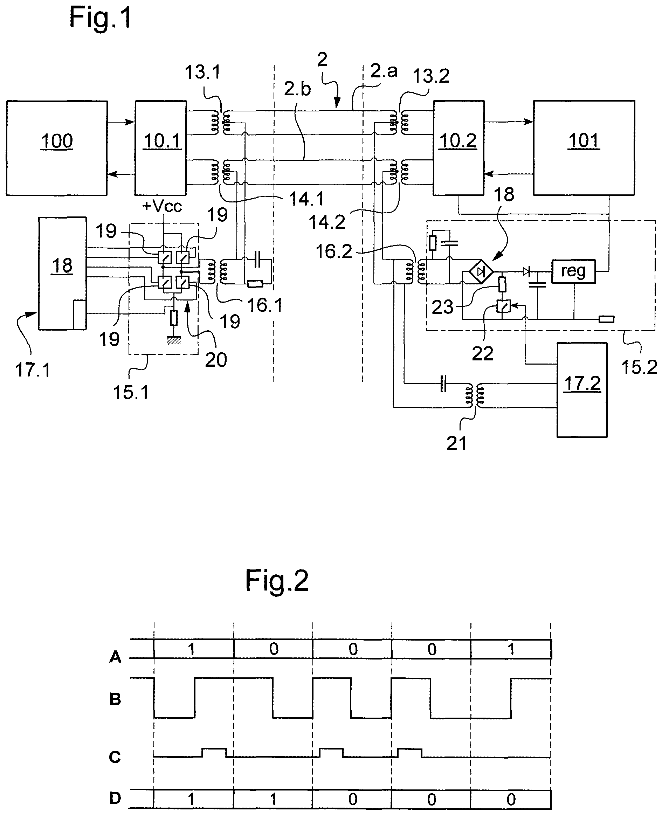

Pour émettre des données, le module de transmission secondaire 17.2 utilise l'horloge de réception des données envoyées par le module de transmission secondaire 17.1 pour synchroniser une horloge d'émission au moyen d'une boucle de verrouillage de phase permettant de créer une commande de consommation sur le flux émis. En agissant sur l'interrupteur 21, la commande de consommation entraîne des sauts ou des pics de consommation dont la position temporelle dans chaque cellule correspond à une donnée. Dans l'exemple représenté à la figure 2, on voit que le courant consommé C présente des pics de consommation : le pic de consommation en début de cellule vaut 0 tandis que le pic de consommation en fin de cellule vaut 1. Le module de transmission secondaire du deuxième équipement est ainsi agencé pour transmettre des données par modulation du courant consommé C, la modulation du courant consommé C étant synchronisée avec un flux de données montant pour coder les données D en fonction d'un positionnement temporel de pics de courant consommé par rapport au flux de données montant.

En réception, le module de transmission secondaire 17.1 détecte les pics de consommation de courant. A partir de la mesure de courant, il est possible après échantillonnage de calculer une valeur moyenne du courant consommé C et de faire apparaître les pics de consommation au moyen d'un différentiateur dans les cellules ou fenêtres temporelles dans lesquelles ils sont positionnés. Les données D en sont alors déduites.

Il est ainsi réalisé une transmission bidirectionnelle simultanée de données.

Bien que cela ne soit pas représenté, on a prévu des moyens de filtrage, ici de type passe-bas, pour empêcher que la transmission des données via les modules de transmission secondaires 17.1, 17.2 ne viennent perturber le flux de données ETHERNET.

Bien entendu, l'invention n'est pas limitée aux modes de réalisations décrits mais englobe toute variante entrant dans le champ de l'invention telle que définie par les revendications.

En particulier, le module d'alimentation 15.2 peut être un module numérique et peut comprendre un dispositif de correction du facteur de puissance ou PFC.

En variante, les modules de transmission sont agencés pour assurer une transmission bidirectionnelle par alternance.

## Revendications

1. Dispositif de connexion (1) d'un premier équipement électronique (100) à un deuxième équipement électronique (101), comportant deux interfaces de type ETHERNET (10.1, 10.2) reliées entre elles par une ligne montante (2.b) et une ligne descendante (2.a) et agencées pour être reliées chacune à l'un des équipements et transmettre des données en mode différentiel, **caractérisé par** deux modules d'alimentation (15.1, 15.2) associés chacun à l'un des équipements et montés en mode commun entre les lignes montante et descendante pour transmettre un signal porteur d'alimentation en courant alternatif, et deux modules de transmission secondaire (17.1, 17.2) associés chacun à un des modules d'alimentation et agencés pour permettre une transmission de données par modulation du signal porteur d'alimentation.

2. Dispositif selon la revendication 1, dans lequel le module de transmission secondaire (17.1) du premier équipement (100) est agencé pour effectuer une modulation par saut de phase.

3. Dispositif selon la revendication 1, dans lequel le module de transmission secondaire (17.2) du deuxième équipement (101) est agencé pour transmettre des données par modulation du courant consommé.

4. Dispositif selon la revendication 3, dans lequel la modulation du courant consommé est synchronisée avec un flux de données montant pour coder les données en fonction d'un positionnement temporel de pics de courant consommé par rapport au flux de données montant.

5. Dispositif selon la revendication 1, dans lequel les modules de transmission (17.1, 17.2) sont agencés pour assurer une transmission bidirectionnelle simultanée.

6. Dispositif selon la revendication 1, dans lequel les modules de transmission (17.1, 17.2) sont agencés pour assurer une transmission bidirectionnelle par alternance.

7. Procédé de transmission de données entre un premier équipement électronique (100) et un deuxième équipement électronique (101) connectés l'un à l'autre par un dispositif de connexion (1) comprenant deux interfaces de type ETHERNET (10.1, 10.2) reliées entre elles par une ligne montante (2.b) et une ligne descendante (2.a) et agencées pour être reliées chacune à l'un des équipements, deux modules d'alimentation (15.1, 15.2) associés chacun à l'un des équipements et montés en mode commun entre les lignes montante et descendante pour transmettre un signal porteur d'alimentation en courant alternatif, et deux modules de transmission secondaire (17.1, 17.2) associés chacun à un des modules d'alimentation et agencés pour permettre une transmission de données par modulation du signal porteur d'alimentation.

8. Procédé selon la revendication 7, dans lequel :
- un premier des modules de transmission secondaire transforme les données en un flux bi-phase par modulation de la tension du signal porteur d'alimentation de manière correspondante,
- un deuxième des modules de transmission secondaire se synchronise sur le flux bi-phase et transforme ledit flux pour récupérer les données transmises.

9. Procédé selon la revendication 8, dans lequel:
- pour transmettre des données, le deuxième module de transmission secondaire module le courant consommé dans le deuxième équipement électronique, la modulation du courant consommé étant synchronisé avec un flux de données montant pour coder les données en fonction d'un positionnement temporel de pics de courant consommé par rapport au flux de données montant,
- pour recevoir les données, le premier module de transmission détecte les pics de consommation de courant,
- à partir de la mesure de courant et après échantillonnage, une valeur moyenne du courant consommé est calculé pour faire apparaitre les pics de consommation au moyen d'un différentiateur dans les cellules ou fenêtres temporelles dans lesquelles ils sont positionnés afin d'en déduire les données.

10. Procédé selon la revendication 9, dans lequel le deuxième de transmission secondaire utilise une horloge de réception des données envoyées par le premier module de transmission secondaire pour synchroniser une horloge d'émission au moyen d'une boucle de verrouillage de phase permettant de créer une commande de consommation sur le flux émis de manière à ce que la commande de consommation entraîne des sauts ou des pics de consommation dont la position temporelle dans chaque cellule correspond à une donnée.

## Patentansprüche

1. Verbindungsvorrichtung (1) zur Verbindung eines ersten elektronischen Geräts (100) mit einem zweiten elektronischen Gerät (101), umfassend zwei ETHERNET-Schnittstellen (10.1, 10.2), die miteinander über eine Aufwärts-Leitung (2.b) und eine Abwärts-Leitung (2.a) verbunden und so ausgebildet sind, dass sie jeweils mit einem der Geräte verbunden werden können und Daten im Gegentaktbetrieb übertragen können, **gekennzeichnet durch** zwei Stromversorgungsmodule (15.1, 15.2), die jeweils mit einem der Geräte verbunden und im Gleichtakt zwischen der Aufwärts-Leitung und der Abwärts-Leitung geschaltet sind, um ein Trägersignal zur Versorgung mit Wechselstrom zu übertragen, und zwei sekundäre Übertragungsmodule (17.1, 17.2), die jeweils mit einem der Stromversorgungsmodule verbunden und so ausgebildet sind, dass sie eine Datenübertragung **durch** Modulation des Stromversorgungs-Trägersignals gestatten.

2. Vorrichtung nach Anspruch 1, bei der das sekundäre Übertragungsmodul (17.1) des ersten Geräts (100) so ausgebildet ist, dass es eine Modulation durch Phasensprung durchführt.

3. Vorrichtung nach Anspruch 1, bei der das sekundäre Übertragungsmodul (17.2) des zweiten Geräts (101) so ausgebildet ist, dass es Daten durch Modulation des verbrauchten Stroms überträgt.

4. Vorrichtung nach Anspruch 3, bei der die Modulation des Stromverbrauchs mit einem Aufwärts-Datenfluss synchronisiert ist, um die Daten in Abhängigkeit von einer zeitlichen Positionierung der Spitzen des verbrauchten Stroms in Bezug auf den Aufwärts-Datenfluss zu kodieren.

5. Vorrichtung nach Anspruch 1, bei der die Übertragungsmodule (17.1, 17.2) so ausgebildet sind, dass sie eine gleichzeitige bidirektionale Übertragung gewährleisten.

6. Vorrichtung nach Anspruch 1, bei der die Übertragungsmodule (17.1, 17.2) so ausgebildet sind, dass sie eine abwechselnde bidirektionale Übertragung gewährleisten.

7. Verfahren zur Übertragung von Daten zwischen einem ersten elektronischen Gerät (100) und einem zweiten elektronischen Gerät (101), die miteinander über eine Verbindungsvorrichtung (1) verbunden sind, die zwei ETHERNET-Schnittstellen (10.1, 10.2) umfasst, die miteinander über eine Aufwärts-Leitung (2.b) und eine Abwärts-Leitung (2.a) verbunden und so ausgebildet sind, dass sie jeweils mit einem der Geräte verbunden werden können, zwei Stromversorgungsmodule (15.1, 15.2), die jeweils mit einem der Geräte verbunden und im Gleichtakt zwischen der Aufwärts-Leitung und der Abwärts-Leitung geschaltet sind, um ein Trägersignal zur Versorgung mit Wechselstrom zu übertragen, sowie zwei sekundäre Übertragungsmodule (17.1, 17.2), die jeweils mit einem der Stromversorgungsmodule verbunden und so ausgebildet sind, dass sie eine Datenübertragung durch Modulation des Stromversorgungs-Trägersignals gestatten.

8. Verfahren nach Anspruch 7, bei dem:
- ein erstes der sekundären Übertragungsmodule die Daten durch entsprechende Modulation der Spannung des Stromversorgungs-Trägersignals in einen Zwei-Phasen-Fluss transformiert,
- ein zweites der sekundären Übertragungsmodule sich auf den Zwei-Phasen-Fluss synchronisiert und den genannten Fluss transformiert, um die übertragenen Daten zurückzugewinnen.

9. Verfahren nach Anspruch 8, bei dem:
- zum Übertragen der Daten das zweite sekundäre Übertragungsmodul den verbrauchten Strom in dem zweiten elektronischen Gerät moduliert, wobei die Modulation des verbrauchten Stroms mit einem Aufwärts-Datenfluss synchronisiert wird, um die Daten in Abhängigkeit von einer zeitlichen Positionierung von Spitzen des verbrauchten Stroms in Bezug auf den Aufwärts-Datenfluss zu kodieren,
- zum Empfangen der Daten das erste Übertragungsmodul die Spitzen des Stromverbrauchs erfasst,
- anhand der Strommessung und nach einer Stichprobenerhebung ein Mittelwert des verbrauchten Stroms berechnet wird, um die Verbrauchsspitzen mittels eines Differenzierers in den zeitlichen Zellen oder Fenstern erscheinen zu lassen, in denen sie positioniert sind, um daraus die Daten abzuleiten.

10. Verfahren nach Anspruch 9, bei dem das zweite sekundäre Übertragungsmodul einen Empfangstakt für die von dem ersten sekundären Übertragungsmodul geschickten Daten verwendet, um einen Sendetakt mittels eines Phasenregelkreises zu synchronisieren, der ein Erzeugen eines Verbrauchsbefehls auf den gesendeten Fluss ermöglicht, derart, dass der Verbrauchsbefehl Verbrauchssprünge oder -spitzen verursacht, deren zeitliche Position in jeder Zelle einem Datenelement entspricht.

## Claims

1. A connection device (1) for connecting a first piece of electronic equipment (100) to a second piece of electronic equipment (101), the device comprising two Ethernet type interfaces (10.1, 10.2) that are linked together by an up line (2.b) and a down line (2.a) and that are arranged for each of them to be linked to a respective one of the pieces of equipment and to transmit data in differential mode, **characterized by** two power supply modules (15.1, 15.2), each associated with a respective one of the pieces of equipment and wired in common mode between the up and down lines in order to transmit a power supply carrier signal in alternating current, and two secondary transmission modules (17.1, 17.2), each associated with a respective one of the power supply modules and arranged to enable data to be transmitted by modulating the power supply carrier signal.

2. A device according to claim 1, wherein the secondary transmission module (17.1) of the first piece of equipment (100) is arranged to perform modulation by phase shift keying.

3. A device according to claim 1, wherein the secondary transmission module (17.2) of the second piece of equipment (101) is arranged to transmit data by modulating current consumption.

4. A device according to claim 3, wherein the modulation of current consumption is synchronized with an up data stream for coding data as a function of the time positions of peaks in the consumed current relative to the up data stream.

5. A device according to claim 1, wherein the transmission modules (17.1, 17.2) are arranged to provide bidirectional transmission simultaneously.

6. A device according to claim 1, wherein the transmission modules (17.1, 17.2) are arranged to provide bidirectional transmission in alternation.

7. Method for transmitting data between a first piece of electronic equipment (100) and a second piece of electronic equipment (101) connected together by a connection device (1) comprising two Ethernet type interfaces (10.1, 10.2) that are linked together by an up line (2.b) and a down line (2.a) linked to a respective one of the pieces of equipment, two power supply modules (15.1, 15.2), each associated with a respective one of the pieces of equipment and wired in common mode between the up and down lines in order to transmit a power supply carrier signal in alternating current, and two secondary transmission modules (17.1, 17.2), each associated with a respective one of the power supply modules, said method comprising the step of transmitting data in differential mode through the up line and the down line and the step of transmitting data by modulating the power supply carrier signal.

8. Method according to claim 7, wherein:
- a first of the secondary transmission modules transforms data into a biphase stream modulating the voltage of the power supply carrier signal correspondingly,
- a second of the secondary transmission modules synchronizes itself on the biphase stream and transforms said stream in order to recover the transmitted data.

9. Method according to claim 8, wherein:
- to transmit data, the second secondary transmission module modulates a consumed current in the second piece of equipment, with modulation of the consumed current being synchronized with an up data stream to code data as a function of time positions of peaks consumed current,
- to receive the data, the first secondary transmission module detects the current consumption peaks,
- on the basis of the detected current and after sampling, a mean value of the consumed current is calculated for revealing consumption peaks by means of a differentiator in the time windows or cells in which the peaks are positioned in order to deduce the data therefrom.

10. Method according to claim 9, wherein the second secondary transmission module uses a data reception clock sent by the first secondary transmission module in order to synchronize a transmit clock by means of a phase locked loop serving to create a consumption command on the transmitted stream in such a way the consumption command leads to jumps or peaks of consumption at time positions within cell corresponding to data.
